# EUROPÄISCHE PATENTANMELDUNG

(11) **EP 2 555 233 A1**
(43) Veröffentlichungstag der Anmeldung: **06.02.2013**
(21) Anmeldenummer: 12175872.6
(22) Anmeldetag: 11.07.2012
(51) Int. Cl.: H01L 21/67

(54) **Abluftsystem und Verfahren dazu**

(30) Priorität: 05.08.2011 DE 102011109568
(71) Anmelder: RENA GmbH, 78148 Gütenbach (DE)
(72) Erfinder: Bareis, Dirk, Donaueschingen 78166 (DE); Kaltenbach, Florian, 78141 Schönwald (DE); Roccia, Pasquale, 78136 Schonach (DE); Sprenger, Holger, 78148 Gütenbach (DE); Lindert, André, 78050 Villingen (DE)
(74) Vertreter: Stürken, Joachim

(57) **Zusammenfassung**

Die Erfindung betrifft eine Vorrichtung und ein Verfahren zum verbesserten Abtransport von mit reaktiven Gasen belasteter Luft im Rahmen der nasschemischen Durchlaufbehandlung von Substraten.

Eine erfindungsgemäße Vorrichtung zum Entfernen gasförmiger Reaktionsprodukte (2) aus einer Durchlaufanlage (1) zur einseitigen nasschemischen Behandlung flacher Gegenstände (3) mittels eines Transportgases (G) weist einen Eingang (8), ein Behandlungsbecken (4) zur Aufnahme einer Behandlungsflüssigkeit (F), eine Durchlauf-Transporteinrichtung (5) mit einer Transportebene (6) zum horizontalen Transport der flachen Gegenstände (3) in Transportrichtung (7), einen Ausgang (9), sowie eine oberhalb der Transportebene (6) angeordneten Auffangkammer (10) für gasförmige Reaktionsprodukte (2) auf. Sie ist dadurch gekennzeichnet, dass die Auffangkammer (10) unter Bildung eines Abluftkanals (13) im Bereich des Ausganges (9) eine Einströmöffnung (11) und im Bereich des Einganges (8) eine Ausströmöffnung (12) derart aufweist, dass das Transportgas (G) den Abluftkanal (13) entgegen der Transportrichtung (7) sowie im wesentlichen parallel zur Transportebene (6) und zur Transportrichtung (7) durchströmen kann.

## Beschreibung

### Einleitung

Die Erfindung betrifft eine Vorrichtung und ein Verfahren zum verbesserten Abtransport von mit reaktiven Gasen belasteter Luft im Rahmen der chemischen Durchlaufbehandlung von Substraten.

### Stand der Technik und Nachteile

Aus dem Stand der Technik sind Durchlaufanlagen zur nasschemischen Behandlung von flachen Gegenständen bekannt. Derartige Gegenstände sind beispielsweise Siliziumsubstrate, wie sie in der Halbleiter- und Solarzellenfertigung Verwendung finden. Für bestimmte Prozessschritte ist eine lediglich einseitige nasschemische Behandlung solcher Substrate erwünscht. Bei dieser Behandlung wird nur eine Seite des Substrats einer Behandlung unterzogen, wohingegen die andere Seite im ursprünglichen Zustand verbleiben soll. Typischerweise erfolgen derartige Behandlungen in nasschemischen Anlagen, wobei die Substrate durch die Behandlungsflüssigkeit, oder entlang ihrer Oberfläche, transportiert werden.

Zur einseitigen nasschemischen Behandlung sind aus dem Stand der Technik verschiedene Verfahren bekannt.

Nach einer ersten Variante wird die nicht zu behandelnde Seite mit einer Schutzschicht geschützt, die vor dem (nasschemischen) Prozessschritt aufzubringen ist, und für gewöhnlich nach diesem Prozessschritt entfernt wieder werden muss. Nachteilig ist hier der zusätzliche Aufwand für die Schutzbeschichtung und -entfernung.

Nach einer anderen Variante liegt die nicht zu behandelnde Seite vollflächig, beispielsweise an einem Vakuumchuck, oder zumindest im Randbereich, der beispielsweise durch eine Dichtlippe gebildet wird, an einer dichtenden Gegenfläche an. Während des nasschemischen Prozessschritts kann so keine Behandlungsflüssigkeit an die nicht zu behandelnde Seite des Substrats gelangen. Nachteilig ist der nicht unerhebliche apparative Aufwand, sowie die Tatsache, dass die häufig berührungsempfindliche Substratfläche durch die schützende Gegenfläche beschädigt oder verschmutzt werden kann.

Nach einer weiteren Variante wird das zu behandelnde Substrat derartig entlang der Oberfläche der Behandlungsflüssigkeit geführt, dass nur seine Unterseite und ggf. seine Kanten mit der Behandlungsflüssigkeit in Kontakt kommen. Ein solches Behandlungsverfahren ist beispielsweise in der EP 1 733 418 beschrieben. Sofern der Transport durch die Behandlungsflüssigkeit entsprechend vorsichtig erfolgt, bleibt die Oberseite des Substrats unbehandelt, ohne dass es einer Schutzschicht oder der Berührung durch eine Gegenfläche bedürfe.

Ein Problem sind jedoch die häufig bei der nasschemischen Behandlung auftretenden, von der chemischen Reaktion herrührenden Gasbläschen, beispielsweise Stickoxide (NOₓ), welche sich an der Unterseite des Substrats anreichern, um schließlich, in Transportrichtung gesehen, an der Hinterkante des eckigen bzw. im hinteren Bereich des runden Substrats an die Flüssigkeitsoberfläche zu steigen, wo sie schließlich zerplatzen. Beim Zerplatzen der Gasbläschen können feine Tröpfchen entstehen, die in unerwünschter Weise die Oberseite, und dort insbesondere den nach hinten weisenden Bereich, des Substrats kontaminieren und das Behandlungsergebnis negativ beeinflussen. Zudem ist die (ungeschützte) Substratoberseite diesen sowie ggf. weiteren reaktiven Gasen ausgesetzt, was ebenfalls zu unerwünschten Veränderungen dieser Seite führen kann.

Anschließend reichern sich die Reaktionsgase im Bereich oberhalb der Behandlungsflüssigkeit und der Substrate an. Daher sehen derartige Durchlaufanlagen typischerweise eine Absaugung der Reaktionsgase vor. Die Absaugung der bekannten Anlagen erfolgt dabei immer unmittelbar vertikal nach oben, typischerweise durch ein Schutzgitter hindurch. Um ein schnelles Abführen der Reaktionsgase zu bewirken, arbeitet die Absaugung gewöhnlich unter Volllast. Somit ist eine weitere Anhebung der Leistung der Absaugung nicht mehr möglich. Das Schutzgitter stellt einen zusätzlichen fluidischen Widerstand dar, der die Volumenleistung der Absaugung weiter mindert. Eine weitere Vergrößerung der Leistungsaufnahme ist jedoch nicht wirtschaftlich, so dass die Konzentration unerwünschter gasförmiger Reaktionsprodukte trotz der Absaugung hoch bleibt. Problematisch bei derartigen Absaugungen ist außerdem, dass sich Wellen an der Oberfläche der Behandlungsflüssigkeit bilden können, die zu einer Benetzung der Oberseite eines Substrats führen. Zudem kann ein aufwärts gerichteter, zu starker Sog zu einem Anheben der Substrate führen, was in jedem Fall zu vermeiden ist. Auch kann nicht vollständig ausgeschlossen werden, dass der vertikale Sog die beim Zerplatzen der Gasblasen freiwerdenden Flüssigkeitströpfchen auf die Oberseite der Substrate schleudert.

### Aufgabe der Erfindung und Lösung

Die Aufgabe der Erfindung besteht daher in der Bereitstellung einer Vorrichtung und eines Verfahrens, welche bzw. welches eine einseitige, nasschemische Behandlung flacher Gegenstände wie z.B. Siliziumsubstrate unter Absaugung der entstehenden Reaktionsgase erlaubt, wobei die oben genannte Problematik der unerwünschten Benetzung der Oberseite aufgrund zerplatzender Gasbläschen vermieden wird, ohne dass einen Schutz dieser Seite nötig wäre. Auf eine weitere Anhebung der Leistungsaufnahme soll dabei verzichtet werden.

Die Erfindung soll ferner dazu geeignet sein, bestehende Vorrichtungen auf einfache und kostengünstige Weise zu modifizieren, um dem Problem der ungenügenden Absaugung zu begegnen.

Die Aufgabe wird durch eine Vorrichtung gemäß Hauptanspruch sowie ein Verfahren nach Anspruch 8 gelöst. Weitere bevorzugte Ausführungsformen sind den Unteransprüchen, der Beschreibung sowie den Figuren zu entnehmen.

### Beschreibung

Nachfolgend wird zunächst die der Erfindung zugrunde liegende Vorrichtung beschrieben. Alsdann erfolgt eine Darstellung des mit einer derartigen Vorrichtung durchführbaren erfindungsgemäßen Verfahrens.

Die erfindungsgemäße Vorrichtung dient dem Entfernen gasförmiger Reaktionsprodukte aus einer Durchlaufanlage, die ihrerseits zur einseitigen nasschemischen Behandlung flacher Gegenstände vorgesehen ist. Die Vorrichtung umfasst einen Eingang, ein Behandlungsbecken zur Aufnahme einer Behandlungsflüssigkeit, die beispielsweise eine Ätz- oder Reinigungsflüssigkeit sein kann; eine Durchlauf-Transporteinrichtung mit einer Transportebene zum horizontalen Transport der flachen Gegenstände in eine Transportrichtung entlang einer Transportstrecke, wobei als Transporteinrichtung beispielsweise Rollen, Gurte, Bänder oder Balken in Betracht kommen; einen Ausgang, durch welchen die zu behandelnden Gegenstände in die Vorrichtung ein- bzw. aus ihr ausfahren; sowie eine oberhalb der Transportebene angeordnete Auffangkammer für gasförmige Reaktionsprodukte. Die Transportrichtung wird durch die Richtung vom Eingang zum Ausgang definiert. Typischerweise ist diese Auffangkammer seitlich durch entsprechende Wände, und nach oben hin durch eine Decke begrenzt. Die Vorrichtung ist erfindungsgemäß dadurch gekennzeichnet, dass die Auffangkammer unter Bildung eines Abluftkanals im Bereich des Ausganges eine Einströmöffnung und im Bereich des Einganges eine Ausströmöffnung derart aufweist, dass der Abluftkanal mit dem Transportgas entgegen der Transportrichtung durchströmbar ist.

Mit anderen Worten, die Vorrichtung weist im Bereich des einen Endes der Transportstrecke eine Einströmöffnung, und im Bereich des anderen Endes der Transportstrecke eine Ausströmöffnung auf, so dass zwischen Frischlufteingang und Abluftausgang ein die Auffangkammer umfassender Abluftkanal ausgebildet ist, der in horizontaler Richtung gleichmäßig mit dem eingangs erwähnten Transportgas durchströmbar ist. Somit unterscheidet sich die erfindungsgemäße Vorrichtung von einer bekannten Vorrichtung dadurch, dass die Abluft, also das mit gasförmigen Reaktionsprodukten beladene Transportgas, nicht in vertikaler Richtung abgeführt wird, sondern zumindest eine Strömungskomponente aufweist, welche parallel zur Transportebene verläuft.

Der sich somit einstellende Gasstrom verläuft im Wesentlichen horizontal, also parallel zur Transportebene, und außerdem parallel zur Transportrichtung. Ein Anheben der Substrate durch einen starken Sog, oder die Erzeugung von Wellen, welche die Substratoberfläche kontaminieren könnten, wird wirkungsvoll verhindert. Da sich auf dem Weg vom Frischlufteingang zum Abluftausgang keine strömungstechnischen Hindernisse im Gasstrom befinden, ist eine geringere Leistung als bei vertikal arbeitenden Vorrichtungen ausreichend.

Der Effekt der Verhinderung der Kontamination wird insbesondere dadurch erreicht, dass der Frischlufteingang im Bereich des Ausgangs, und der Abluftausgang im Bereich des Eingangs angeordnet ist, so dass der Abluftkanal vom Ausgang zum Eingang der Vorrichtung mit Transportgas durchströmbar ist. Dementsprechend erfolgt die Durchströmung mit Transportgas entgegen der Transportrichtung. Der Effekt der erfindungsgemäßen Anordnung von Frischlufteingang und Abluftausgang ist der, dass die eingangs erwähnten Tröpfchen, die von den Gasbläschen herrühren, welche im hinteren Bereich eines Substrats aufsteigen und dort zerplatzen, von der Oberfläche eines Substrats weg transportiert werden. Somit kann der feine Nebel aus Tröpfchen nicht mehr auf die Oberfläche desjenigen Substrates gelangen, an dessen Hinterkante das Gasbläschen aufgestiegen war, welches die Tröpfchen erzeugte.

Es ist klar, dass der Abstand zu einem vorhergehenden Substrat ausreichend groß sein muss, um eine Kontamination des diesem nachfolgenden Substrates durch Tröpfchen zu vermeiden, die an der Hinterkante des vor ihm befindlichen entstanden sind.

Bevorzugt ist, dass die Einströmöffnung durch den Ausgang, und/oder die Ausströmöffnung durch den (Substrat-)Eingang der Vorrichtung gebildet sind. Dadurch wird eine besonders einfache Konstruktion der Vorrichtung erreicht.

Alternativ können auch spezielle Öffnungen im Bereich des Eingangs und den Ausgangs vorgesehen sein, durch welche das Transportgas in die Vorrichtung ein- und wieder aus ihr austritt. Derartige Öffnungen können beispielsweise unmittelbar oberhalb oder seitlich des Ein- und/oder Ausgangs angeordnet sein. Außerdem sind auch Rohrleitungen, welche das Transportgas an anderer Stelle einsaugen bzw. ausgeben, denkbar, sofern diese an entsprechender Stelle im Bereich des Ein- bzw. Ausgangs enden bzw. beginnen.

Es ist klar, dass zum Fördern des Transportgases eine entsprechende Gasfördereinrichtung vorhanden oder der Vorrichtung funktional zugeordnet sein muss. Dementsprechend ist bevorzugt, dass die erfindungsgemäße Vorrichtung eine im Bereich des Abluftkanals angeordnete und/oder fluidisch mit diesem verbundene Gasfördereinrichtung aufweist. Es ist auch klar, dass mehrere derartige Gasfördereinrichtungen vorhanden sein können, die jeweils Teilsegmente der erfindungsgemäßen Vorrichtung mit Frischluft versorgen bzw. aus diesen Abluft absaugen. Ebenso ist es möglich, Einblas- und Absaugeinrichtungen miteinander zu kombinieren. Die Einrichtung(en) kann bzw. können unmittelbar in der Auffangkammer angeordnet sein (z.B. als Ventilatoren), oder das Transportgas wird temporär, und ohne die erfindungsgemäße horizontale Durchströmung wesentlich zu verändern, durch vertikal oder seitlich herausgeführte Rohrleitungen geführt, wo es entsprechend beschleunigt wird.

Nach einer besonders bevorzugten Ausführungsform weist die Vorrichtung eine Saugglocke auf, welche im Bereich des Eingangs angeordnet ist. Diese weist Saugglockenöffnungen ausreichender Größe auf, in welche die Abluft eingesogen und aus der Vorrichtung gefördert wird. Besonders bevorzugt sind die Saugglockenöffnungen im Bereich des Abluftkanals (in der Gasphase, horizontale Absaugung) angeordnet. Alternativ sind sie oberhalb des Abluftkanals (oberhalb der Gasphase, vertikale Absaugung) positioniert.

Nach einer weiteren Ausführungsform umfasst die Vorrichtung Mittel zur Beeinflussung der Strömungsgeschwindigkeit des Transportgases, also der Frisch- und/oder der Abluft. Derartige Mittel sind bevorzugt Drosselklappen oder dergleichen, die den Querschnitt der die Frischluft zuführenden und/oder der Abluft abführenden Bauteile ändern, so dass die Stärke des Abluftstroms und Änderung der Leistung der Gasfördereinrichtung in geeigneter Weise beeinflusst werden kann.

Besonders bevorzugt weist dann die Vorrichtung auch eine Steuerung zum Regeln der Gasfördereinrichtung bzw. der Mittel zur Beeinflussung der Strömungsgeschwindigkeit auf. Somit kann die Änderung der Strömungsgeschwindigkeit auch automatisiert erfolgen.

Es ist nach einer weiteren Ausführungsform vorgesehen, dass die erfindungsgemäße Vorrichtung Mittel zum horizontalen Ausrichten des Stroms des Transportgases aufweist. Das bedeutet, dass das möglicherweise zunächst vertikal oder seitwärts in die Auffangkammer einströmende Transportgas über Blenden, Leitbleche oder dergleichen derart umlenkbar ist, dass die erfindungsgemäße Strömung zustande kommt. Es ist klar, dass das Gesagte sinngemäß auch für das Ausströmen des Transportgases bzw. der Abluft gelten kann.

Besonders bevorzugt sind zur Umlenkung der typischerweise von oben in den Abluftkanal einströmenden Frischluft eine oder mehrere Umlenkglocken vorhanden, die sich im Bereich des (Substrat-)Ausgangs, also am Ende der Transportstrecke, befinden. Zur Homogenisierung kann Luft aus einem bevorzugt perforierten Deckelbereich (Gitter) in eine solche Umlenkglocke geleitet werden. Das Transportgas verlässt die Umlenkglocke schließlich in horizontaler Richtung und somit parallel zur Transportebene und den in ihr transportierten flachen Gegenständen, sowie gerade entgegen der Transportrichtung.

Besonders bevorzugt ist die Fläche der Perforation mindestens gleich groß wie die Fläche der Öffnung(en) der Umlenkglocke(n). Die Fläche dieser Öffnungen ist dabei bevorzugt mindestens gleich groß wie die Fläche der vorstehend genannten Saugglockenöffnungen der bevorzugt vorhandenen Saugglocke.

Nach einer weiteren Ausführungsform sind im Bereich der Auffangkammer mindestens eine weitere Einströmöffnung und/oder Ausströmöffnung angeordnet. Dies ist immer dann vorteilhaft, wenn die erfindungsgemäße Vorrichtung sehr lang ist, oder wenn eine Auffangkammer unterschiedliche Behandlungsbäder und somit Segmente umfasst. Besonders bevorzugt ist dann jeder dieser Ein- und/oder Ausgänge mit einer separaten Gasfördereinrichtung verbunden. Auf diese Weise kann immer eine ausreichende Transportgeschwindigkeit des Transportgases gewährleistet werden, ohne extrem leistungsstarke Gasfördereinrichtungen vorzusehen, oder es kann dafür gesorgt werden, dass unterschiedliche Reaktionsgase, die in unterschiedlichen Segmenten der Durchlaufanlage entstehen, nicht miteinander vermischt werden. Ebenso lassen sich auf einfache Weise unterschiedliche und leicht variierbare Strömungsgeschwindigkeiten und ggf. Strömungsrichtungen erzeugen, sofern die Gasfördereinrichtungen entsprechend flexibel steuerbar sind.

Nach einer besonders bevorzugten Ausführungsform ist das Transportgas Luft. Selbstverständlich sind auch andere Gase, abhängig von der jeweiligen Anwendung, denkbar. Auch reinigende oder behandelnde Gase gehören hierzu.

Des weiteren ist die bevorzugte Durchflussmenge Transportgases, bezogen auf 1 m² Querschnitt des Abluftkanals, auf 0,1 bis 5 m³/min, und besonders bevorzugt auf 1 m³/min, eingestellt, und/oder die entgegen der (und parallel zur) Transportrichtung weisende Komponente der Strömungsgeschwindigkeit beträgt im Bereich der Transportebene 0,01 bis 5 m/s, und besonders bevorzugt 1 m/s.

Die Erfindung kann auch zur Bereitstellung eines Umrüstsatzes zum Umrüsten einer Vorrichtung, wie sie aus dem Stand der Technik bekannt ist, dienen. Demnach umfasst ein derartiger Umrüstsatz Sperrplatten zum Verschließen von ursprünglichen, zur vertikalen Durchströmung vorgesehenen, die Auffangkammer nach oben hin begrenzenden Abluftöffnungen, sowie einen im Bereich des Eingangs oder des Ausgangs anzuordnenden Frischlufteingang und/oder Abluftausgang, wobei der Frischlufteingang eine fluidische Verbindung nach Außen, und der Abluftausgang eine fluidische Verbindung zu einer Gasfördereinrichtung aufweist. Mit anderen Worten, der Umrüstsatz stellt alle wesentlichen Komponenten bereit, um eine herkömmliche Anlage mit vertikaler Abluftabsaugung in eine erfindungsgemäße Anlage mit horizontaler Durchströmung umzubauen. Es ist klar, dass bevorzugt sowohl Frischlufteingang als auch Abluftausgang bereitgestellt werden, und dass die Verschaltung der typischerweise bereits vorhandenen Gasfördereinrichtung zu einer Durchströmung entgegen der Transportrichtung führt. Es ist auch klar, dass weitere, oben beschriebene Komponenten, wie insbesondere Mittel zum horizontalen Ausrichten des Stroms des Transportgases, vom beschriebenen Umrüstsatz umfasst sein können.

Nach einer bevorzugten Ausführungsform des beschriebenen Umrüstsatzes weist die oberhalb des Abluftausgangs anzuordnende Sperrplatte (und nur diese) einen Durchbruch zur darüber befindlichen ursprünglichen Abluftöffnung auf. Auf diese Weise wird sichergestellt, dass die Abluft lediglich am Ende des Strömungsweges durch die Abluftkammer, und somit am Eingang der umgerüsteten Durchlaufanlage, in (wenn auch) vertikaler Richtung abgesogen wird, wohingegen sie im übrigen Bereich der Auffangkammer lediglich und in erfindungsgemäßer Weise horizontal strömen kann, da die ursprünglich vorhandenen vertikalen Öffnungen durch die übrigen Sperrplatten verschlossen sind.

Wie weiter oben erwähnt, betrifft die Erfindung auch ein Verfahren zum Transportgas vermittelten Entfernen gasförmiger Reaktionsprodukte aus einer Durchlaufanlage zur einseitigen nasschemischen Behandlung flacher Gegenstände.

Demnach betrifft die Erfindung ein Verfahren zum Entfernen gasförmiger Reaktionsprodukte aus einer Durchlaufanlage zur einseitigen nasschemischen Behandlung flacher Gegenstände mittels eines Transportgases unter Verwendung einer Vorrichtung gemäß obiger Definition, wobei das Verfahren dadurch gekennzeichnet ist, dass das Transportgas im Abluftkanal entgegen der Transportrichtung sowie im wesentlichen parallel zur Transportebene und zur Transportrichtung geführt wird .

Um Wiederholungen zu vermeiden, wird auf die obenstehenden Erläuterungen bezüglich der erfindungsgemäßen Vorrichtung verwiesen.

Grundlegend weist die Strömungsrichtung des Transportgases zum Abtransport der gasförmigen Reaktionsprodukte eine oder mehrere parallel zur Transportrichtung verlaufende Komponente(n) auf. Jeder Vektor der Strömung an einem Ort im Inneren der Auffangkammer weist eine oder mehrere dieser Komponenten auf, beispielsweise eine vertikale, eine in Transportrichtung weisende, und eine seitlich gerichtete Komponente, die senkrecht auf den beiden andren Komponenten steht. Somit verlaufen die Komponenten vorzugsweise auf den Achsen eines rechtwinkligen Koordinatensystems, welches mit den entsprechenden Hauptrichtungen der Durchlaufanlage übereinstimmt. Erfindungsgemäß darf nun die parallel zur Transportebene und parallel zur Transportrichtung weisende Komponente nicht Null sein, und sie muss entgegen der Transportrichtung verlaufen. Das bedeutet, dass sich die Strömung nicht ausschließlich aus vertikalen Komponenten zusammensetzt. Für den Fall, dass die Strömung segmentweise verläuft, also keinen durchgehend vom Eingang zum Ausgang und zur Transportebene parallelen Verlauf haben kann, sind sinngemäß die jeweiligen Komponenten der Einzel- oder Segmentströmungen in entsprechender Weise auszurichten. Letzteres ist insbesondere dann der Fall, wenn die Durchlaufanlage mehrere Abluftkanal-Segmente umfasst, die jeweils separat voneinander die erfindungsgemäßen Strömungskomponenten aufweisen. Sofern nichts anders genannt ist, wird nachfolgend zur Vereinfachung vom Vorhandensein eines einzigen Abluftkanals ausgegangen.

Nach einer bevorzugten Ausführungsform weist die Strömungsrichtung des Transportgases ausschließlich solche Komponenten auf, die parallel zur Transportebene verlaufen. Das bedeutet, dass die Strömung nur noch aus horizontalen Komponenten besteht. Derartige Komponenten können beispielsweise quer zur Transportrichtung, also (in Transportrichtung gesehen) von links nach rechts und/oder umgekehrt verlaufen.

Nach einer weiteren, besonders bevorzugten Ausführungsform weist die Strömungsrichtung des Transportgases zusätzlich ausschließlich solche Komponenten auf, die parallel zur Transportrichtung verlaufen. Das bedeutet, dass die Strömung nur aus horizontalen Komponenten besteht, welche in und/oder entgegen der Transportrichtung verlaufen.

Es ist klar, dass eine Komponente, die parallel zur Transportebene verläuft, nicht zwingend auch parallel zur Transportrichtung verlaufen muss. Umgekehrt verläuft jedoch eine Komponente, die parallel zur Transportrichtung verläuft, zwingend auch parallel zur Transportebene.

Bevorzugt ist ferner, dass diese Komponenten nicht nur parallel zur Transportebene, sondern auch soweit als möglich parallel zur Transportrichtung, also zwischen Ein- und Ausgang der Durchlaufanlage verlaufen.

Besonders bevorzugt ist, dass (zumindest möglichst) jede/alle Komponente(n) vom Ausgang zum Eingang gerichtet ist bzw. sind, und somit entgegen der Transportrichtung weisen. Es ist klar, dass beispielsweise im Bereich der Einströmöffnung und/oder der Ausströmöffnung aus konstruktiven Gründen von dieser Richtung abgewichen werden muss, ohne den erfindungsgemäßen Gedanken zu verlassen. Bei besagter Gegenströmung ist dies insbesondere im Eingangsbereich der Durchlaufanlage unproblematisch, denn hier sind noch keine Gasbläschen zu erwarten, da die Behandlung der Substrate gerade erst begonnen hat.

Bevorzugt ist auch, dass das Transportgas eine Strömung aufweist, die durch mindestens eine im Bereich des Abluftkanals angeordnete und/oder fluidisch mit diesem verbundene Gasfördereinrichtung erzeugt und/oder durch Mittel zum horizontalen Ausrichten des Stroms des Transportgases ausgerichtet, also umgelenkt, wird. Die hierzu vorzugsweise zu verwendenden Einrichtungen und Mittel wurden bereits weiter oben beschrieben, weshalb an dieser Stelle auf eine Wiederholung verzichtet wird.

Nach einer weiteren Ausführungsform hängt der Grad oder die Stärke der Umlenkung von der Strömungsgeschwindigkeit ab. Das bedeutet, dass bei geringen Strömungsgeschwindigkeiten eine stärkere, abruptere Umlenkung möglich ist als bei hohen Strömungsgeschwindigkeiten, die eine sanftere Umlenkung mit größeren Radien und strömungsgünstigeren Formen benötigt.

Geringe Strömungsgeschwindigkeiten liegen im Bereich von 0,01 bis 1 m/s, wohingegen hohe Strömungsgeschwindigkeiten 5 m/s und mehr betragen können.

Nach einer weiteren Ausführungsform wird die Geschwindigkeit der Strömung des Transportgases im Abluftkanal in Abhängigkeit der im Transportgas abgeführten Konzentration von gasförmigen Reaktionsprodukten gesteuert. Für geringere Konzentrationen ist demnach eine geringere Strömungsgeschwindigkeit ausreichend. Auf diese Weise kann möglichst ökonomisch auf die jeweiligen Gegebenheiten reagiert werden. Vorzugsweise sind entsprechende Sensoren vorgesehen, die die Belastung der Abluft messen und an die Steuerung der Gasfördereinrichtung bzw. entsprechend vorgesehene Drosselklappen weitergeben, so dass eine bedarfsgerechte Regelung der Strömungsgeschwindigkeit ermöglicht wird.

Nachfolgend wird die Erfindung schematisch in einer bevorzugten Ausführungsform anhand von Figuren erläutert.

### Figurenbeschreibung

- **Figur 1**: zeigt eine Durchlaufanlage mit einer Abluftvorrichtung nach dem Stand der Technik.
- **Figur 2**: zeigt eine Durchlaufanlage mit einer erfindungsgemäßen Vorrichtung.
- **Figur 3**: zeigt die Situation im Bereich eines einzelnen flachen Gegenstands bei Durchführung des erfindungsgemäßen Verfahrens.

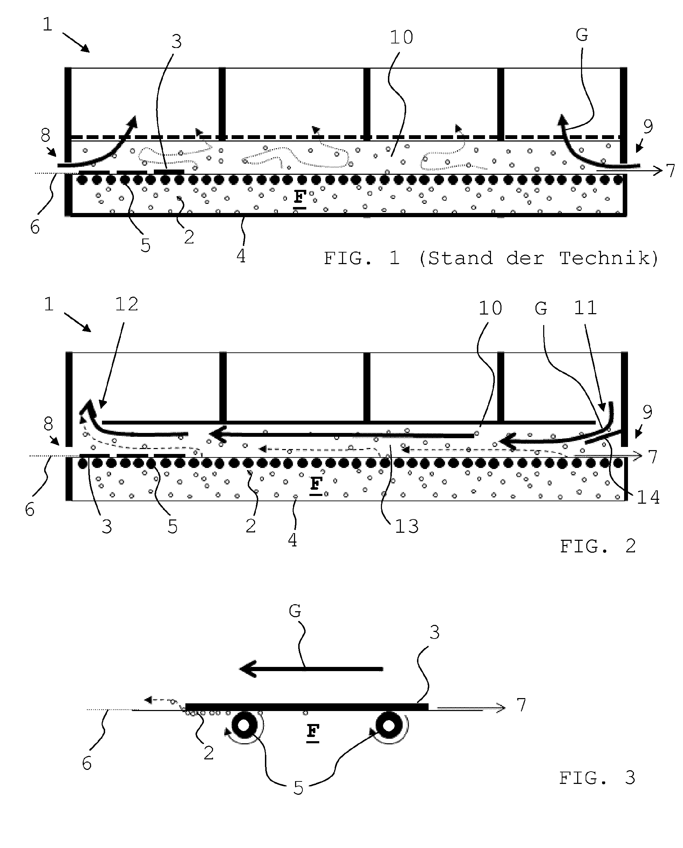

Die in der **Figur 1** gezeigte Vorrichtung gibt grob schematisch den Aufbau der Ablufteinrichtung einer bekannten Durchlaufanlage 1 wieder. Die Anlage besteht aus einem Behandlungsbecken 4, welches mit einer Behandlungsflüssigkeit F gefüllt ist. An der Oberfläche der Behandlungsflüssigkeit F werden flache Gegenstände 3, vorliegend auch Substrate genannt, horizontal in Transportrichtung 7 auf der Transportebene 6 entlanggeführt. Hierzu wird eine Durchlauf-Transporteinrichtung 5 verwendet, die im gezeigten Beispiel eine größere Anzahl ausreichend dicht hintereinander angeordneter Rollen aufweist (im Bild als große, ausgefüllte Kreise gezeigt). Die Substrate 3 werden aufgrund ihrer vertikal genau eingestellten Position lediglich einseitig, nämlich an ihrer Unterseite, durch die Behandlungsflüssigkeit F behandelt.

Oberhalb des mit Behandlungsflüssigkeit F gefüllten Behandlungsbeckens 4 befindet sich eine Auffangkammer 10. Diese ist durch ein Gitter von einer Abluftkammer getrennt, die sich oberhalb der Auffangkammer 10 befindet. Die Substrate 3 fahren in die Auffangkammer 10 durch einen Eingang 8 ein, und verlassen sie durch einen Ausgang 9. Die Auffangkammer 10 dient dem Auffangen gasförmiger Reaktionsprodukte 2 (in allen Figuren als kleine, nicht ausgefüllte Kreise dargestellt). Diese Reaktionsprodukte 2 fallen bei der chemischen Behandlung insbesondere an der Unterseite der Substrate 3 an, tauchen aus der Behandlungsflüssigkeit F auf und müssen abtransportiert werden, um eine unerwünschte Behandlung der Substratoberseiten zu verhindern. Hierzu wird ein Transportgas G, vorliegend Umgebungsluft, durch den Eingang 8 und den Ausgang 9 eingesogen. Das Transportgas G nimmt auf seinem Weg durch ein Gitter, welches die Auffangkammer 10 nach oben hin begrenzt, die Reaktionsprodukte 2 mit. Die Strömung des Transportgases G ist durch die dicken, durchgezogenen Pfeile symbolisiert. Einige der Strömungspfade der Reaktionsprodukte 2 sind durch die dünnen, punktiert gezeichneten Pfeile symbolisiert. Wie aus der Figur 1 ersichtlich, verlaufen diese Pfade nicht auf dem kürzesten Weg von der Oberfläche der Behandlungsflüssigkeit F zu dem und durch das Gitter, sondern driften zunächst in unkontrollierter Weise durch die Auffangkammer 10, bis sie sich ausreichend nah am Gitter befinden. Der Grund für dieses Verhalten ist die im zentralen Bereich der Auffangkammer 10 zu geringe vertikale Strömung des Transportgases G. Daher besteht gerade im zentralen Bereich die erhöhte Gefahr einer unerwünschten Behandlung der Substratoberseiten durch die gasförmigen Reaktionsprodukte 2. Ferner spritzen Tröpfchen, die sich bilden, unkontrolliert in alle Richtungen (nicht dargestellt), wenn die Reaktionsprodukte 2 die Oberfläche der Behandlungsflüssigkeit F durchtreten. Somit besteht ebenfalls die Gefahr einer Kontamination der Substratoberflächen.

Diese Probleme werden durch die erfindungsgemäße Vorrichtung gemäß **Figur 2** wirkungsvoll vermieden. Die Vorrichtung weist im Bereich des einen Endes der Transportstrecke (Ausgang 9) eine Einströmöffnung 11, und im Bereich des anderen Endes (Eingang 8) der Transportstrecke eine Ausströmöffnung 12 auf, so dass zwischen Einströmöffnung 11 und Ausströmöffnung 12 ein die Auffangkammer 10 umfassender Abluftkanal 13 ausgebildet ist, der in horizontaler Richtung gleichmäßig mit dem eingangs erwähnten Transportgas G entgegen der Transportrichtung 7 durchströmbar ist.

Damit das im Bereich des Ausgangs 9 in die Auffangkammer 10 einströmende Transportgas G möglichst keine vertikale Komponente aufweist, befindet sich dort ein Mittel zum horizontalen Ausrichten 14 des Stroms des Transportgases G, das vorliegend als Prallblech ausgebildet ist.

Da der Abluftkanal 13 erst an seinem Ende, das vorliegend im Bereich des Eingangs 8 der Durchlaufanlage 1 angeordnet ist, eine Ausströmöffnung 12 aufweist, strömt das Transportgas G in Wesentlichen horizontal durch die Auffangkammer 10. Daraus ergeben sich folgende Vorteile.

Die Strömung fließt überall in der Auffangkammer 10 gleich schnell und stark. Ein ungleichmäßiger Abtransport, wie er bei einer bekannten Anlage auftritt, ist nicht zu erwarten.

Da kein Gitter oder ähnliches die Strömung des Transportgases G behindert, kann die Gasfördereinrichtung (nicht dargestellt) entsprechend kleiner dimensioniert werden, oder sie hat - bei gegebener Größe - typischerweise noch eine Leistungsreserve.

Durch die entgegen der Transportrichtung 7 verlaufende Strömung des Transportgases G wird die Kontamination der Substratoberseiten durch Spritzer verhindert.

Dies ist in der **Figur 3** verdeutlicht. Die Transportrichtung 7 verläuft im Bild von links nach rechts, da die Rollen der Durchlauf-Transporteinrichtung 5 sich wie durch die Rotationspfeile angedeutet im Uhrzeigersinn drehen. Die vertikale Lage des Substrats 3 ist exakt so eingestellt, dass nur seine Unterseite mit der Behandlungsflüssigkeit F in Berührung kommt. Ein vergleichbares Behandlungsergebnis wäre im Übrigen auch dann erzielbar, wenn (nach einer nicht dargestellten Variante) die Behandlungsflüssigkeit F durch die Rollen 5 aufgenommen und "indirekt" an das etwas höher als in der Figur dargestellt positionierte Substrat 3 transferiert würde.

Wie erfindungsgemäß gefordert weist die Strömungsrichtung des Transportgases G zum Abtransport der gasförmigen Reaktionsprodukte 2 eine entgegen der Transportrichtung 7 verlaufende Komponente auf. Sie weist sogar vorwiegend solche Komponenten auf, die parallel zur Transportebene 6 verlaufen. Ausnahmen sind der Bereich des Frischlufteingangs 11 sowie des Abluftausgangs 12, wo die Strömung konstruktionsbedingt zunehmend auch vertikale Komponenten aufweist.

Wie ersichtlich steigen gasförmigen Reaktionsprodukte 2, die sich an der Unterseite des Substrats 3 sammeln, im Bereich von dessen Hinterkante (links im Bild) auf. Durch die Strömung des Transportgases G, angedeutet durch den dicken, durchgezogenen Pfeil, werden Spritzer, die sich beim Zerplatzen der Gasbläschen bilden, von der Hinterkante und der Oberfläche des Substrats 3 weg (im Bild nach links) transportiert. Somit ist eine Kontamination der Substratoberseite nicht zu befürchten. Hierdurch unterscheidet sich die erfindungsgemäße Vorrichtung und das erfindungsgemäße Verfahren wesentlich von den aus dem Stand der Technik bekannten Vorrichtungen und Verfahren.

Die Erfindung stellt in vorteilhafter Weise eine Vorrichtung und ein Verfahren bereit, welche bzw. welches eine einseitige, nasschemische Behandlung flacher Gegenstände wie z.B. Siliziumsubstrate unter Absaugung der entstehenden Reaktionsgase erlaubt, wobei die oben genannte Problematik der unerwünschten Benetzung der Oberseite aufgrund zerplatzender Gasbläschen vermieden wird, ohne dass einen Schutz dieser Seite nötig wäre. Eine Ausführungsform ermöglicht eine Modifikation bestehender Vorrichtungen auf einfache und kostengünstige Weise.

### Bezugszeichenliste

- 1: Durchlaufanlage
- 2: gasförmiges Reaktionsprodukt
- 3: flacher Gegenstand, Substrat
- 4: Behandlungsbecken
- 5: Durchlauf-Transporteinrichtung, Rollen
- 6: Transportebene
- 7: Transportrichtung
- 8: Eingang
- 9: Ausgang
- 10: Auffangkammer
- 11: Frischlufteingang, Einströmöffnung
- 12: Abluftausgang, Ausströmöffnung
- 13: Abluftkanal
- 14: Mittel zum horizontalen Ausrichten
- F: Behandlungsflüssigkeit
- G: Transportgas

## Patentansprüche

1. Vorrichtung zum Entfernen gasförmiger Reaktionsprodukte (2) aus einer Durchlaufanlage (1) zur einseitigen nasschemischen Behandlung flacher Gegenstände (3) mittels eines Transportgases (G), mit einem Eingang (8), einem Behandlungsbecken (4) zur Aufnahme einer Behandlungsflüssigkeit (F), einer Durchlauf-Transporteinrichtung (5) mit einer Transportebene (6) zum horizontalen Transport der flachen Gegenstände (3) in Transportrichtung (7), einem Ausgang (9), sowie einer oberhalb der Transportebene (6) angeordneten Auffangkammer (10) für gasförmige Reaktionsprodukte (2), **dadurch gekennzeichnet, dass** die Auffangkammer (10) unter Bildung eines Abluftkanals (13) im Bereich des Ausganges (9) eine Einströmöffnung (11) und im Bereich des Einganges (8) eine Ausströmöffnung (12) derart aufweist, dass das Transportgas (G) den Abluftkanal (13) entgegen der Transportrichtung (7) sowie im wesentlichen parallel zur Transportebene (6) und zur Transportrichtung (7) durchströmen kann.

2. Vorrichtung nach Anspruch 1, wobei die Einströmöffnung (11) durch den Ausgang (9), und/oder die Ausströmöffnung (12) durch den Eingang (8) der Vorrichtung gebildet sind.

3. Vorrichtung nach Anspruch 1 oder 2, welche ferner eine im Bereich des Abluftkanals (13) angeordnete und/oder fluidisch mit diesem verbundene Gasfördereinrichtung, und/oder Mittel zur Beeinflussung der Strömungsgeschwindigkeit des Transportgases (G) aufweist.

4. Vorrichtung nach Anspruch 3, welche ferner eine Steuerung zum Regeln der Gasfördereinrichtung und/oder der Mittel zur Beeinflussung der Strömungsgeschwindigkeit aufweist.

5. Vorrichtung nach einem der vorhergehenden Ansprüche, welche ferner Mittel zum horizontalen Ausrichten (14) des Stroms des Transportgases (G) aufweist.

6. Vorrichtung nach einem der vorhergehenden Ansprüche, in der im Bereich der Auffangkammer (10) mindestens eine weitere Einströmöffnung und/oder Ausströmöffnung angeordnet sind.

7. Vorrichtung nach einem der vorhergehenden Ansprüche, wobei das Transportgas (G) Luft ist, und/oder die Durchflussmenge desselben bezogen auf 1 m² Querschnitt des Abluftkanals (13) auf 0,1 bis 5 m³/min, bevorzugt auf 1 m³/min, eingestellt ist, und/oder die entgegen der Transportrichtung (7) weisende Komponente der Strömungsgeschwindigkeit im Bereich der Transportebene (6) 0,01 bis 5 m/s, bevorzugt 1 m/s, beträgt.

8. Verfahren zum Entfernen gasförmiger Reaktionsprodukte (2) aus einer Durchlaufanlage (1) zur einseitigen nasschemischen Behandlung flacher Gegenstände (3) mittels eines Transportgases (G) unter Verwendung einer Vorrichtung gemäß Definition in einem der Ansprüche 1 bis 7, **dadurch gekennzeichnet, dass** das Transportgas (G) im Abluftkanal (13) entgegen der Transportrichtung (7) sowie im wesentlichen parallel zur Transportebene (6) und zur Transportrichtung (7) geführt wird.

9. Verfahren nach Anspruch 8, wobei die Vorrichtung einen Eingang (8), ein Behandlungsbecken (4) zur Aufnahme einer Behandlungsflüssigkeit (F), eine Durchlauf-Transporteinrichtung (5) mit einer Transportebene (6) zum horizontalen Transport der flachen Gegenstände (3) in Transportrichtung (7), einen Ausgang (9), sowie eine oberhalb der Transportebene (6) angeordnete Auffangkammer (10) für gasförmige Reaktionsprodukte (2) aufweist, und wobei die Auffangkammer (10) unter Bildung eines Abluftkanals (13) im Bereich des Ausganges (9) eine Einströmöffnung (11) und im Bereich des Einganges (8) eine Ausströmöffnung (12) aufweist.

10. Verfahren nach Anspruch 8 oder 9, wobei das Transportgas (G) eine Strömung aufweist, die durch mindestens eine im Bereich des Abluftkanals (13) angeordnete und/oder fluidisch mit diesem verbundene Gasfördereinrichtung erzeugt und/oder durch Mittel zum horizontalen Ausrichten (14) des Stroms des Transportgases (G) umgelenkt wird.

11. Verfahren nach einem der Ansprüche 8 bis 10, wobei die Geschwindigkeit der Strömung des Transportgases (G) im Abluftkanal (13) in Abhängigkeit der im Transportgas (G) abgeführten Konzentration von gasförmigen Reaktionsprodukten (2) gesteuert wird.
